# EUROPEAN PATENT APPLICATION

(11) **EP 4 428 914 A1**
(43) Date of publication of application: **11.09.2024**
(21) Application number: 23160942.1
(22) Date of filing: 09.03.2023
(51) Int. Cl.: H01L 23/053, H01L 23/373, H01L 23/488, H01L 25/07, H01L 23/24

(54) **POWER SEMICONDUCTOR MODULE ARRANGEMENT**

(71) Applicant: Infineon Technologies AG, 85579 Neubiberg (DE)
(72) Inventor: BAYER, Christoph, 97776 Albertshofen (DE); BÜRGER, Matthias, 33181 Bad Wünnenberg (DE); NOLTEN, Ulrich, 59602 Rüthen (DE); ESSERT, Mark, 59519 Möhnesee (DE)
(74) Representative: Westphal, Mussgnug & Partner, Patentanwälte mbB

(57) **Abstract**

A power semiconductor module arrangement comprises a substrate (10) comprising a dielectric insulation layer (11), and a first metallization layer (111) arranged on a first surface of the dielectric insulation layer (11), at least one semiconductor body (20) arranged on and attached to the first metallization layer (111) by means of an electrically conductive connection layer (30), and at least one electrically conducting element (80) arranged on the first metallization layer (111), wherein the first metallization layer (111) is a structured layer comprising a plurality of different subsections, the first metallization layer (111) has a uniform thickness in a vertical direction (y), wherein the vertical direction (y) is perpendicular to the first surface of the dielectric insulation layer (11), each of the at least one electrically conducting element (80) is arranged on and covers a subarea of a sub-section, thereby increasing the cross-sectional area of the subarea of the respective sub-section, and each of the at least one electrically conducting element (80) comprises an electrically conductive connection layer (30) without a semiconductor body (20) arranged thereon.

## Description

### TECHNICAL FIELD

The instant disclosure relates to a semiconductor module arrangement.

### BACKGROUND

Power semiconductor module arrangements often include at least one substrate arranged in a housing. A semiconductor arrangement including a plurality of controllable semiconductor elements (e.g., IGBTs, MOSFETs, HEMTs, etc.) may be arranged on each of the at least one substrate. Each substrate usually comprises a substrate layer (e.g., a ceramic layer), a first metallization layer deposited on a first side of the substrate layer, and a second metallization layer deposited on a second side of the substrate layer. The controllable semiconductor elements are mounted, for example, on the first metallization layer which usually is a structured layer. That is, the first metallization layer is not a continuous layer, but includes recesses between different sections of the layer. A size and shape of the individual sections generally depends on different aspects such as, e.g., specific design specifications. Due to the overall cost of a power semiconductor module, it is generally not desirable to significantly increase the size of a substrate. If integration density increases while keeping the size of the substrate as small as possible, however, the current density may significantly increase in at least some sections of the first metallization layer, especially in areas providing a comparably small cross-sectional area for the current to flow through.

There is a need for a power semiconductor module arrangement that provides an increased current carrying capacity, and that can be produced easily and at low costs.

### SUMMARY

A power semiconductor module arrangement includes a substrate including a dielectric insulation layer, and a first metallization layer arranged on a first surface of the dielectric insulation layer, at least one semiconductor body arranged on and attached to the first metallization layer by means of an electrically conductive connection layer, and at least one electrically conducting element arranged on the first metallization layer, wherein the first metallization layer is a structured layer including a plurality of different sub-sections, the first metallization layer has a uniform thickness in a vertical direction, wherein the vertical direction is perpendicular to the first surface of the dielectric insulation layer, each of the at least one electrically conducting element is arranged on and covers a subarea of a sub-section, thereby increasing the cross-sectional area of the subarea of the respective sub-section, and each of the at least one electrically conducting element includes an electrically conductive connection layer without a semiconductor body arranged thereon.

A method for forming a power semiconductor module arrangement includes attaching at least one semiconductor body to a first metallization layer of a substrate including a dielectric insulation layer and the first metallization layer, by means of an electrically conductive connection layer, and forming at least one electrically conducting element on the first metallization layer, wherein the first metallization layer is a structured layer including a plurality of different sub-sections, the first metallization layer has a uniform thickness in a vertical direction, wherein the vertical direction is perpendicular to the first surface of the dielectric insulation layer, each of the at least one electrically conducting element is formed on and covers a subarea of a sub-section, thereby increasing the cross-sectional area of the subarea of the respective sub-section, and each of the at least one electrically conducting element includes an electrically conductive connection layer without a semiconductor body arranged thereon.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a top view of a power semiconductor module arrangement.
Figure 3, including Figures 3A and 3B, schematically illustrates different cross-sections of a metallization layer of a power semiconductor module arrangement.
Figure 4 is a top view of a power semiconductor module arrangement according to embodiments of the disclosure.
Figure 5 schematically illustrates a cross-sectional view of a power semiconductor module arrangement according to embodiments of the disclosure.
Figure 6 schematically illustrates a cross-sectional view of a power semiconductor module arrangement according to further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

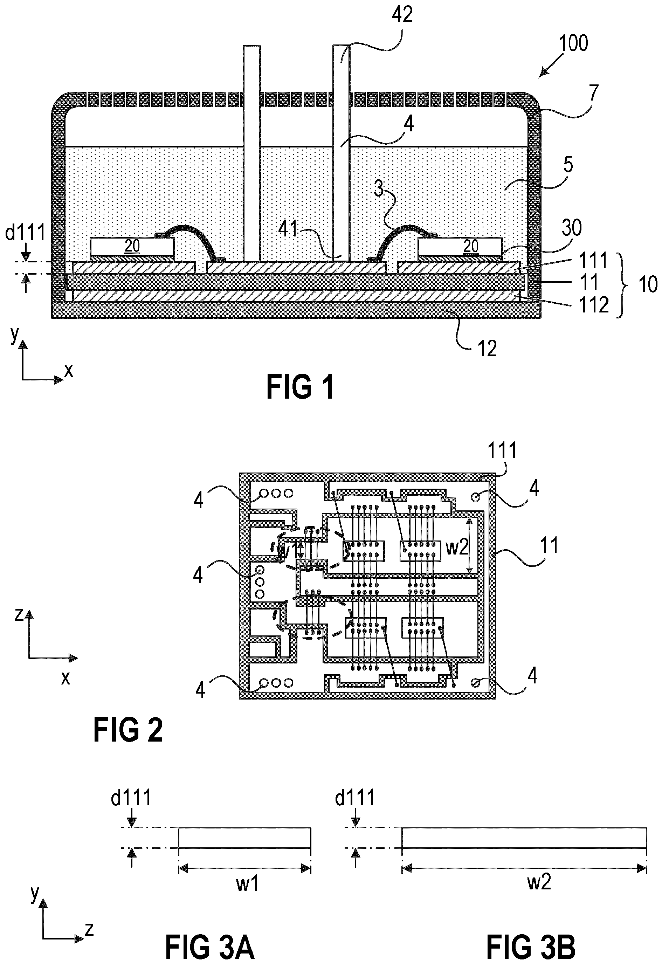

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This, however, is only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. It is also possible that the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sub-sections of the layer. Such recesses are schematically illustrated in Figure 1. The first metallization layer 111 in this example includes three different sub-sections. This, however, is only an example. Any other number of sub-sections is possible. Different semiconductor bodies 20 may be mounted to the same or to different sub-sections of the first metallization layer 111. Different sub-sections of the first metallization layer 111 may be coupled to the same or to different electrical potentials and may have no electrical connection or may be electrically connected to one or more other sub-sections using electrical connection elements 3 such as, e.g., bonding wires or bonding ribbons. Electrical connections 3 may also include connection plates, conductor rails, or connection clips, for example, to name just a few examples. Each of the one or more semiconductor bodies 20 may be electrically and mechanically connected to the substrate 10 by means of an electrically conductive connection layer 30. Such an electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer. The second layer 112, however, may also be omitted.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

The power semiconductor module arrangement 100 may further include an encapsulant 5. An encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

Now referring to Figure 2, a top view of an exemplary substrate 10 is schematically illustrated. The first metallization layer 11 1in the example illustrated in Figure 2 comprises a plurality of different sub-sections. At least some of the sub-sections are electrically contacted by means of terminal elements 4, as has been described with respect to Figure 1 above. The different sub-sections may be electrically coupled to different electrical potentials by means of the terminal elements 4. In the example illustrated in Figure 2, a plurality of semiconductor bodies 20 is arranged on one of the sub-sections. The semiconductor bodies 20 may be electrically coupled to the respective sub-section by means of electrically conductive connection layers 30, similar to what has been described with respect to Figure 1 above. The semiconductor bodies 20 may also be electrically coupled to other sub-sections by means of one or more electrical connections 3. When the terminal elements 4 are coupled to respective electrical potentials, a current flows through the terminal elements 4, at least some of the sub-sections, at least some of the semiconductor bodies 20, and through the respective electrical connections.

Depending on the specific application a power semiconductor module arrangement is used in, more sub-sections of the first metallization layer 111, more semiconductor bodies 20, more terminal elements and more electrical connections may be required. The layout of a power semiconductor module arrangement, therefore, may be very specific. In order to keep the overall size of the substrate 10 as small as possible, due to cost reasons, the different sub-sections of the metallization layer may be comparably small in size. Even further, at least some of the sub-sections may have irregular forms. However, some applications require that comparably large currents flow through at least some of the sub-sections of the first metallization layer 111. If integration density of a power semiconductor module arrangement increases while keeping the size of the substrate as small as possible, however, the current density may significantly increase in some sub-sections of the first metallization layer, especially in areas providing a comparably small cross-sectional area for the current to flow through.

Figure 2 schematically illustrates a sub-section having different widths and, therefore, different cross sections, which is further schematically illustrated in Figures 3A and 3B. In particular, a sub-section of the first metallization layer 111 may comprise at least one narrow subarea (indicated by means of a dashed oval in Figure 2) and at least one broad subarea, wherein each of the at least one narrow subarea has a first width w1 (Figure 3A) and a resulting cross-sectional area (d111 * w1) that is smaller than a second width w2 (Figure 3B) and a resulting cross-sectional area (d111 * w2) of each of the at least one broad subarea. A current density in a narrow subarea, therefore, will be significantly higher than in a broad subarea. A sub-section of the first metallization layer can have more than two subareas having different widths. A sub-section can have any regular or irregular shape, depending on the specific layout of the power semiconductor module arrangement. The general principle of embodiments of the present disclosure, however, will be described with regard to the narrow subareas and the broad subareas as indicated in Figures 2, 3A and 3B.

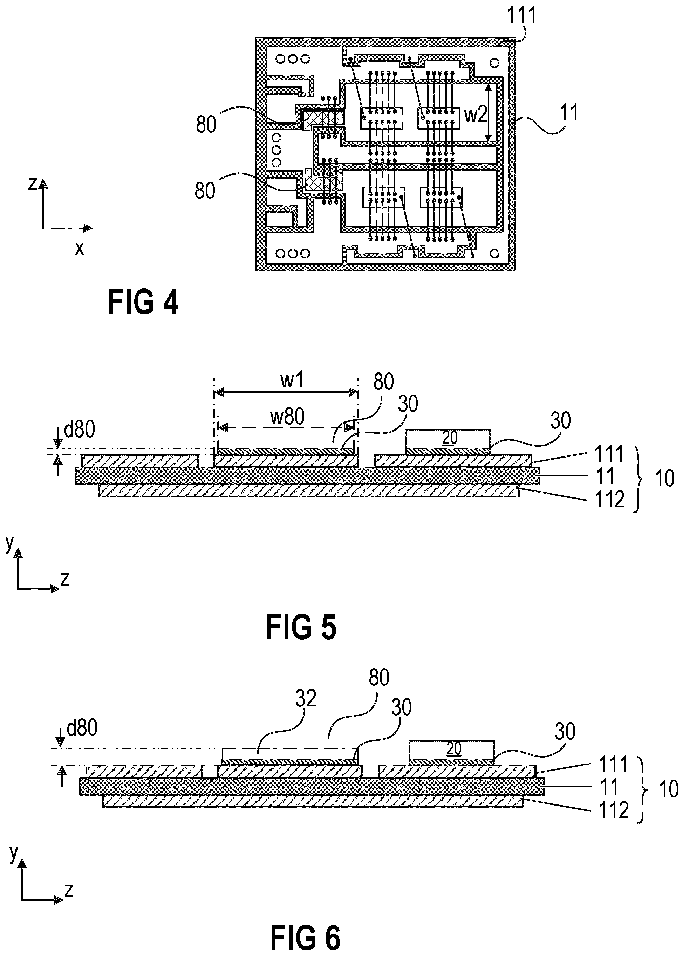

Now referring to Figure 4, the cross-sectional area of at least one subarea of the first metallization layer 111 is increased by arranging an electrically conducting element 80 on the respective subarea. Each of the at least one electrically conducting elements 80 covers a subarea, section or fraction of a respective sub-section, but may not cover the entire sub-section. An electrically conducting element 80 may be arranged on a narrow subarea having a smaller width and cross-sectional area as compared to other subareas of the same sub-section. This, however, is only an example. It is also possible that an electrically conducting element 80 be arranged on a subarea of a sub-section of the first metallization layer 111 that is broader as compared to other sections of the same sub-section. Due to layout constraints, for example it may be possible that even a maximum width of a sub-section is too small in order to be able to conduct the currents arising in the specific design. Therefore, it may be desirable to increase the thickness of a subarea of the respective sub-section, even though it is broad as compared to other subareas of the same sub-sections. Generally speaking, an electrically conducting element 80 may be arranged on any subarea of the first metallization layer 111 in order increase the thickness and, therefore, the cross-sectional area of the respective subarea.

Now referring to Figure 5, an electrically conducting element 80 comprises an electrically conductive connection layer 30. However, no semiconductor body 20 is arranged on an electrically conductive connection layer 30 of an electrically conducting element 80. The electrically conductive connection layer 30 of an electrically conducting element 80 has the sole function of increasing the thickness of the respective subarea of the first metallization layer 111. The electrically conductive connection layer 30, like the electrically conductive connection layers 30 that are used to attach the one or more semiconductor bodies 20 to the first metallization layer 111, may be a solder layer, a layer of an electrically conductive adhesive, or a layer of a sintered metal powder, e.g., a sintered silver powder, for example. According to one example, each of the at least one electrically conductive connection layer 30 attaching the at least one semiconductor body 20 to the first metallization layer 111 consists of the same material as each of the at least one electrically conductive connection layer 30 of the at least one electrically conducting element 80.

That is, the one or more semiconductor bodies 20 may be mounted to the first metallization layer 111 by means of a solder layer comprising or consisting of a first material, e.g., PbSnAg (or any other suitable material commonly used for soldering). Each of the at least one electrically conducting element 80 may comprise a solder layer comprising or consisting of the same first material. This allows to form all electrically conductive connection layers 30 at the same time. In particular, when the one or more semiconductor bodies 20 are soldered to the first metallization layer 111, the one or more electrically conducting elements 80 may be formed at the same time. The one or more semiconductor bodies 20 may be arranged on the first metallization layer 111 with an electrically conductive connection layer 30 arranged between each of the one or more semiconductor bodies 20 and the first metallization layer 111. The electrically conductive connection layers 30 of the one or more electrically conducting elements 80 may be formed at the same time, without a semiconductor body 20 arranged thereon. In a next step, the arrangement may be heated, thereby attaching the one or more semiconductor bodies 20 to the first metallization layer 111. During the heating step, the electrically conductive connection layers 30 of the one or more electrically conducting elements 80 will melt as well. The same applies when the electrically conductive connection layers 30 are all sinter layers, for example.

In the example illustrated in Figure 5, each of the one or more electrically conducting elements 80 is formed solely by an electrically conductive connection layer 30. That is, a thickness d80 of the electrically conducting element 80 in the vertical direction y corresponds to the thickness of the electrically conductive connection layer 30. This, however, is only an example. As is schematically illustrated in Figure 6, it is also possible that an electrically conducting element 80 further comprises a metal foil or plate 32 attached to the first metallization layer 111 by the respective one of the at least one electrically conducting connection layer 30. The metal foil or plate 32 generally may comprise any metallic material. For example, the first metallization layer 111 may consist of or may comprise copper or aluminum. The at least one metal foil or plate 32 of the at least one electrically conducting element 80 may also consist of or may comprise copper or aluminum. It is possible that the material of the metal foil or plate 32 is the same as the material of the first metallization layer 111. It is, however, also possible that the materials are different. However, the first metallization layer 111 has a first coefficient of thermal expansion CTE1 (the CTE depending on the material used for the first metallization layer 111), and the metal foil or plate 32 comprises a second coefficient of thermal expansion CTE2 (the CTE depending on the material used for the metal foil or plate 32). The first coefficient of thermal expansion CTE1 and the second coefficient of thermal expansion CTE2 may be the same or may at least be similar to each other in order to avoid typical problems that may arise when two components attached to each other have significantly different coefficients of thermal expansion. For example, the following may apply: 0.9*CTE1 < CTE2 < 1.1*CTE1. When an electrically conducting element 80 comprises an electrically conducting connection layer 30 and a metal foil or plate 32 arranged thereon, its thickness d80 in the vertical direction y corresponds to the sum of the thickness of the electrically conductive connection layer 30 and the thickness of the metal foil or plate 32.

It is generally possible that a power semiconductor module arrangement only comprises one or more electrically conducting elements 80 as illustrated in Figure 5, or only one or more electrically conducting elements 80 as illustrated in Figure 6. It is, however, also possible that one and the same power semiconductor module arrangement comprises one or more electrically conducting elements 80 as illustrated in Figure 5, as well as one or more electrically conducting elements 80 as illustrated in Figure 6. That is, different kinds of electrically conducting elements 80 may be combined in one and the same power semiconductor module arrangement.

The thickness d80 of the at least one electrically conducting element 80 in the vertical direction y may be at least 10µm, or at least 50µm. A certain minimum thickness is generally required in order to result in a noticeable effect of the electrically conducting elements 80 (increase of thickness is large enough to noticeably increase the current carrying capability of the respective subarea). The electrically conducting elements 80 may generally have any thickness above this minimum thickness.

A width w80 of an electrically conducting element 80 may correspond to the width of the respective subarea of the first metallization layer 111 it is arranged on. As is schematically illustrated in Figure 5, it is however also possible that an electrically conducting element 80 is narrower than the subarea of the first metallization layer 111 it is arranged on. That is, the respective subarea may have a first width w1 in a horizontal direction, and the respective electrically conducting element 80 arranged thereon may have a width w80 that is less than the first width w1. There may be thin strips of the subarea towards its edges that are not covered by the electrically conducting element 80. This may be because of technical production considerations, e.g., in order to avoid the material of the electrically conductive connection layer 30 from flowing into the gap between the two sub-sections of the first metallization layer 111.

Each of the one or more electrically conducting elements 80 may be arranged on a subarea of the first metallization layer 111, for which an increase of its cross-sectional area is desired. This may apply for very narrow subareas that need to conduct large currents. However, even some broader subareas may benefit from an electrically conducting element 80 arranged thereon. By increasing the cross-sectional area of subareas of the structured first metallization layer 111, the overall lifetime of the power semiconductor module arrangement may be significantly increased, as the current density in the concerned subareas may be significantly decreased.

## Claims

1. A power semiconductor module arrangement comprises
a substrate (10) comprising a dielectric insulation layer (11), and a first metallization layer (111) arranged on a first surface of the dielectric insulation layer (11);
at least one semiconductor body (20) arranged on and attached to the first metallization layer (111) by means of an electrically conductive connection layer (30); and
at least one electrically conducting element (80) arranged on the first metallization layer (111), wherein
the first metallization layer (111) is a structured layer comprising a plurality of different sub-sections,
the first metallization layer (111) has a uniform thickness in a vertical direction (y), wherein the vertical direction (y) is perpendicular to the first surface of the dielectric insulation layer (11),
each of the at least one electrically conducting element (80) is arranged on and covers a subarea of a sub-section, thereby increasing the cross-sectional area of the subarea of the respective sub-section, and
each of the at least one electrically conducting element (80) comprises an electrically conductive connection layer (30) without a semiconductor body (20) arranged thereon.

2. The power semiconductor module arrangement of claim 1, wherein
at least one of the sub-sections comprises a narrow subarea and a broad subarea, wherein the narrow subarea has a first width (w1) and a resulting cross-sectional area that is smaller than a second width (w2) and a resulting cross-sectional area of the broad subarea, and
each of the at least one electrically conducting element (80) is arranged on a narrow subarea, thereby increasing the cross-sectional area of the narrow subarea.

3. The power semiconductor module arrangement of claim 1 or 2, wherein each of the at least one electrically conducting elements (80) has a third width (w80) in a horizontal direction that is perpendicular to the vertical direction (y), wherein the third width (w80) is less than a width of the respective subarea it is mounted on in the same horizontal direction.

4. The power semiconductor module arrangement of any of claims 1 to 3, wherein an electrically conductive connection layer (30) is a solder layer, a layer of an electrically conductive adhesive, or a layer of a sintered metal powder.

5. The power semiconductor module arrangement of any of claims 1 to 4, wherein each of the at least one electrically conductive connection layer (30) attaching the at least one semiconductor body (20) to the first metallization layer (111) consists of the same material as each of the at least one electrically conductive connection layer (30) of the at least one electrically conducting element (80).

6. The power semiconductor module arrangement of any of the preceding claims, wherein at least one of the at least one electrically conducting element (80) further comprises a metal foil or plate (32), wherein each of the at least one metal foil or plate (32) is attached to the first metallization layer (111) by the respective one of the at least one electrically conducting connection layer (30).

7. The power semiconductor module arrangement of claim 6, wherein
the first metallization layer (111) consists of or comprises copper or aluminum, and
the at least one metal foil or plate (32) consist of or comprises copper or aluminum.

8. The power semiconductor module arrangement of any of the preceding claims, wherein a thickness (d80) of the at least one electrically conducting element (80) in the vertical direction (y) is at least 10µm, or at least 50µm.

9. The power semiconductor module arrangement of any of claims 6 to 8, wherein the first metallization layer (111) comprises a first coefficient of thermal expansion CTE1, the metal foil or plate (32) comprises a second coefficient of thermal expansion CTE2, and wherein 0.9*CTE1 < CTE2 < 1.1*CTE1.

10. A method for producing a power semiconductor module arrangement, wherein the method comprises
attaching at least one semiconductor body (20) to a first metallization layer (111) of a substrate (10) comprising a dielectric insulation layer (11) and the first metallization layer (111), by means of an electrically conductive connection layer (30); and
forming at least one electrically conducting element (80) on the first metallization layer (111), wherein
the first metallization layer (111) is a structured layer comprising a plurality of different sub-sections,
the first metallization layer (111) has a uniform thickness in a vertical direction (y), wherein the vertical direction (y) is perpendicular to the first surface of the dielectric insulation layer (11),
each of the at least one electrically conducting element (80) is formed on and covers a subarea of a sub-section, thereby increasing the cross-sectional area of the subarea of the respective sub-section, and
each of the at least one electrically conducting element (80) comprises an electrically conductive connection layer (30) without a semiconductor body (20) arranged thereon.

11. The method of claim 10, wherein the steps of attaching at least one semiconductor body (20) to the first metallization layer (111), and forming the at least one electrically conducting element (80) on the first metallization layer (111) are performed simultaneously.

12. The method of claim 10 or 11, wherein
the step of attaching at least one semiconductor body (20) to the first metallization layer (111) comprises a soldering or a sintering process, and
the step of forming at least one electrically conducting element (80) on the first metallization layer (111) comprises a soldering or a sintering process.

13. The method of any of claims 10 to 12, wherein the step of forming at least one electrically conducting element (80) on the first metallization layer (111) comprises attaching at least one metal foil or plate (32) to the first metallization layer (111) by means of an electrically conductive connection layer (30).

## Amended claims

### Amended claims in accordance with Rule 137(2) EPC.

1. A power semiconductor module arrangement comprises
a substrate (10) comprising a dielectric insulation layer (11), and a first metallization layer (111) arranged on a first surface of the dielectric insulation layer (11);
at least one semiconductor body (20) arranged on and attached to the first metallization layer (111) by means of an electrically conductive connection layer (30); and
at least one electrically conducting element (80) arranged on the first metallization layer (111), wherein
the first metallization layer (111) is a structured layer comprising a plurality of different sub-sections,
the first metallization layer (111) has a uniform thickness in a vertical direction (y), wherein the vertical direction (y) is perpendicular to the first surface of the dielectric insulation layer (11),
each of the at least one electrically conducting element (80) is arranged on and covers a subarea of a sub-section, thereby increasing the cross-sectional area of the subarea of the respective sub-section,
each of the at least one electrically conducting element (80) comprises an electrically conductive connection layer (30) without a semiconductor body (20) arranged thereon,
at least one of the sub-sections comprises a narrow subarea and a broad subarea, wherein the narrow subarea has a first width (w1) and a resulting cross-sectional area that is smaller than a second width (w2) and a resulting cross-sectional area of the broad subarea, and
each of the at least one electrically conducting element (80) is arranged on a narrow subarea, thereby increasing the cross-sectional area of the narrow subarea.

2. The power semiconductor module arrangement of claim 1, wherein each of the at least one electrically conducting elements (80) has a third width (w80) in a horizontal direction that is perpendicular to the vertical direction (y), wherein the third width (w80) is less than a width of the respective subarea it is mounted on in the same horizontal direction.

3. The power semiconductor module arrangement of any of claims 1 to 2, wherein an electrically conductive connection layer (30) is a solder layer, a layer of an electrically conductive adhesive, or a layer of a sintered metal powder.

4. The power semiconductor module arrangement of any of claims 1 to 3, wherein each of the at least one electrically conductive connection layer (30) attaching the at least one semiconductor body (20) to the first metallization layer (111) consists of the same material as each of the at least one electrically conductive connection layer (30) of the at least one electrically conducting element (80).

5. The power semiconductor module arrangement of any of the preceding claims, wherein at least one of the at least one electrically conducting element (80) further comprises a metal foil or plate (32), wherein each of the at least one metal foil or plate (32) is attached to the first metallization layer (111) by the respective one of the at least one electrically conducting connection layer (30).

6. The power semiconductor module arrangement of claim 5, wherein
the first metallization layer (111) consists of or comprises copper or aluminum, and
the at least one metal foil or plate (32) consist of or comprises copper or aluminum.

7. The power semiconductor module arrangement of any of the preceding claims, wherein a thickness (d80) of the at least one electrically conducting element (80) in the vertical direction (y) is at least 10µm, or at least 50µm.

8. The power semiconductor module arrangement of any of claims 5 to 7, wherein the first metallization layer (111) comprises a first coefficient of thermal expansion CTE1, the metal foil or plate (32) comprises a second coefficient of thermal expansion CTE2, and wherein 0.9*CTE1 < CTE2 < 1.1*CTE1.

9. A method for producing a power semiconductor module arrangement, wherein the method comprises
attaching at least one semiconductor body (20) to a first metallization layer (111) of a substrate (10) comprising a dielectric insulation layer (11) and the first metallization layer (111), by means of an electrically conductive connection layer (30); and
forming at least one electrically conducting element (80) on the first metallization layer (111), wherein
the first metallization layer (111) is a structured layer comprising a plurality of different sub-sections,
the first metallization layer (111) has a uniform thickness in a vertical direction (y), wherein the vertical direction (y) is perpendicular to the first surface of the dielectric insulation layer (11),
each of the at least one electrically conducting element (80) is formed on and covers a subarea of a sub-section, thereby increasing the cross-sectional area of the subarea of the respective sub-section,
each of the at least one electrically conducting element (80) comprises an electrically conductive connection layer (30) without a semiconductor body (20) arranged thereon,
at least one of the sub-sections comprises a narrow subarea and a broad subarea, wherein the narrow subarea has a first width (w1) and a resulting cross-sectional area that is smaller than a second width (w2) and a resulting cross-sectional area of the broad subarea, and
each of the at least one electrically conducting element (80) is arranged on a narrow subarea, thereby increasing the cross-sectional area of the narrow subarea.

10. The method of claim 9, wherein the electrically conductive connection layers (30) for attaching the at least one semiconductor body (20) to the first metallization layer (111), and the electrically conductive connection layers (30) of the one or more electrically conducting elements (80) are formed at the same time.

11. The method of claim 9 or 10, wherein
the step of attaching at least one semiconductor body (20) to the first metallization layer (111) comprises a soldering or a sintering process, and
the step of forming at least one electrically conducting element (80) on the first metallization layer (111) comprises a soldering or a sintering process.

12. The method of any of claims 9 to 11, wherein the step of forming at least one electrically conducting element (80) on the first metallization layer (111) comprises attaching at least one metal foil or plate (32) to the first metallization layer (111) by means of an electrically conductive connection layer (30).
